# EUROPEAN PATENT SPECIFICATION

(11) **EP 3 142 829 B1**
(45) Date of publication and mention of the grant of the patent: **04.10.2023**
(21) Application number: 15731679.5
(22) Date of filing: 14.05.2015
(51) Int. Cl.: B23P 19/00, B65G 47/14, B25J 9/00, B65G 37/02, B23P 21/00, B25J 15/00

(54) **ELECTRONIC APPARATUS PRODUCTION SYSTEM**
SYSTEM ZUR HERSTELLUNG EINER ELEKTRONISCHEN VORRICHTUNG
SYSTÈME DE PRODUCTION D'APPAREIL ÉLECTRONIQUE

(30) Priority: 14.05.2014 CN 201410202796
(43) Date of publication of application: 22.03.2017
(73) Proprietor: Tyco Electronics (Shanghai) Co. Ltd., Shanghai 200233 (CN); Tyco Electronics (Dongguan) Ltd., Dongguan, Guangdong 523958 (CN); TE Connectivity Solutions GmbH, 8200 Schaffhausen (CH); Zhuhai Yingzhi Tech Co. Ltd., Zhuhai, Guangdong (CN)
(72) Inventor: SHEN, Hongzhou, Dongguan Guangdong (CN); ZHANG, Dandan, Caohejing Shanghai 200233 (CN); WONG, Kok Wai, Zhuhai Guangdong (CN); DUBNICZKI, George, Berwyn, Pennsylvania 19312 (US)
(74) Representative: Grünecker Patent- und Rechtsanwälte PartG mbB
(86) International application number: PCT/IB2015/053552
(87) International publication number: WO 2015/173761

(56) References cited:
- WO-A1-2011/145313
- CN-U- 202 922 583
- DE-A1-102011 107 967
- DE-U1-202011 002 465
- JP-A- H 106 154
- JP-A- S63 295 135
- JP-A- 2002 326 127
- JP-A- 2003 170 319
- KR-B1- 100 787 186
- US-A- 5 319 845
- US-A1- 2010 063 629

## Description

### BACKGROUND OF THE INVENTION

### Field of the Invention

The present invention relates to an electronic apparatus production system, more particularly, relates to an electronic apparatus production system configured to assemble scattered different components with different shapes into an electronic apparatus.

### Description of the Related Art

Generally, an electronic apparatus, for example, an electrical connector, a fiber optic connector, a relay or the like, comprises a great number of components, such as a case, a contact, a spring, a bolt, an insulation block, etc. During manufacturing such electronic apparatus, it needs to prepare the components with different shapes and different functions in advance, then select these components manually or by a robot according to a preset program, and assemble these components into an electronic apparatus on a worktable by a robot.

JP S63 925135 A and DE 10 2011 107967 A1 disclose assembling apparatuses with separate supplies for different components. More particularly, JP S63 925235 A discloses: an apparatus production system suitable for electronic production, comprising:
a transmission rail in the form of a substantially closed loop;
a plurality of storage tray circulating on the transmission rail, each of the storage trays comprising a plurality of holding portions to hold components with different shapes; at least one automatic distributing equipment configured to mount the components with different shapes on the respective holding portions;
and at least one automatic assembling equipment configured to grip the components from the storage tray.

### SUMMARY OF THE INVENTION

According to the present invention, there is provided an electronic apparatus production system according to claim 1 configured to assemble scattered different components with different shapes into an electronic apparatus.

According to the present invention, there is provided an electronic apparatus production system, comprising: a transmission rail in the form of a substantially closed loop; a plurality of storage trays circulating along with the transmission rail, each of the storage trays comprising a plurality of holding portions to hold the different components with different shapes; at least one automatic distributing equipment configured to mount the different components with different shapes on the respective holding portions; and at least one automatic assembling equipment configured to grip the different components with different shapes from the storage tray.

According to the invention, the automatic distributing equipment comprises: a base; a storage device mounted on the base and configured to store the plurality of scattered different components with different shapes; a recognition device configured to recognize the different components with different shapes placed on the storage device; a pickup device configured to pick up the recognized components different components with different shapes and place the picked different components with different shapes on the respective holding portions of the storage tray according to a recognition result of the recognition device Preferred embodiments of the electronic production system are presented in the dependent claims.

In the above electronic apparatus production system, preferably the storage device comprises a support tray configured to place the plurality of components.

In the above electronic apparatus production system, preferably the storage device further comprises a first support seat mounted on the base, and the support tray is mounted on the first support seat.

In the above electronic apparatus production system, preferably the support tray has a substantially circular shape, and the storage device further comprises a first motor mounted on the first support seat, and the first motor is configured to drive the support tray to rotate.

In the above electronic apparatus production system, preferably a plurality of division plates extending in a radial direction are provided on the support tray, so as to divide the support tray into a plurality of storage sections having a substantially fanlike shape.

In the above electronic apparatus production system, preferably a ring-shaped blocking plate is provided on the periphery of the support tray, so as to block the components from falling out of the support tray.

In the above electronic apparatus production system, preferably a fanlike blocking plate is provided on the support tray, so as to block the components from falling out of the support tray.

In the above electronic apparatus production system, preferably the storage device further comprises a vibration device mounted on the base under the support tray and configured to vibrate the support tray.

In the above electronic apparatus production system, preferably the recognition device comprises: a first support frame mounted on the base; and a camera mounted on the first support frame to capture images of the components stored on the storage device.

In the above electronic apparatus production system, preferably the recognition device further comprises: a light source configured to illuminate the components stored on the storage device.

In the above electronic apparatus production system, preferably the automatic distributing equipment further comprises: a first transmission device configured to transmit the components onto the storage device.

In the above electronic apparatus production system, preferably the first transmission device comprises: a second support seat mounted on the base; a conveyer belt assembly mounted on the second support seat and comprising a receiving end for receiving the components and a releasing end for releasing the components; and a second motor mounted on the second support seat and configured to drive a conveyer belt of the conveyer belt assembly to move.

In the above electronic apparatus production system, preferably the automatic distributing equipment further comprises: a loading device configured to load the components onto the receiving end of the conveyer belt assembly.

In the above electronic apparatus production system, preferably the loading device comprises: a rolling drum, orientated in a substantially horizontal direction, into which the receiving end of the conveyer belt assembly is inserted in a substantially horizontal direction; a driving device configured to drive the rolling drum to rotate; and at least a scraping plate mounted on an inner wall of the rolling drum in an axial direction.

In the above electronic apparatus production system, preferably the loading device further comprises: an input device communicated with an inner space of the rolling drum at the other end of the rolling drum opposite to one end of the rolling drum for inserting the receiving end of the conveyer belt assembly, so as to input the components into the rolling drum.

In the above electronic apparatus production system, preferably the driving device comprises: a third support seat mounted on the base; a third motor mounted on the third support seat; and a plurality of rolling shafts mounted on the third support seat and rotatably engaged with an outer surface of the rolling drum, so as to drive the rotation of the rolling drum under the driving of the third motor.

In the above electronic apparatus production system, preferably an angle of a surface of the conveyer belt assembly with respect to a horizontal plane is adjustable in a lateral direction perpendicular to a transmitting direction of the conveyer belt.

In the above electronic apparatus production system, preferably the second support seat comprises at least two arcuate brackets each comprising: an arcuate groove; a plurality of through holes arranged in an arcuate shape along the periphery of the arcuate groove; and a lateral bracket on which the conveyer belt assembly is mounted, wherein both ends of the lateral bracket are selectively engaged in two through holes of the plurality of through holes, so that the lateral bracket strides on a portion of the arcuate groove in a changeable posture.

In the above electronic apparatus production system, preferably the pickup device is a first robot and comprises a plurality of grippers adapted to pick up the components with different shapes.

In the above electronic apparatus production system, preferably the base comprises comprising: a plurality of wheels mounted on a bottom of the base; and a plurality of support legs telescopically mounted on the bottom of the base.

The above electronic apparatus production system preferably further comprises at least one pre-distributing equipment each comprising: at least one distributing disk on each of which a plurality of single type of components are pre-placed; and a second robot configured to grip the components from the distributing disk and mount the gripped components on the storage tray.

The above electronic apparatus production system preferably further comprises at least one third robot mounted at downstream of the automatic distributing equipment in a moving direction of the storage tray, each of the at least one third robot configured to pre-assemble some of the components mounted on the storage tray.

In the above electronic apparatus production system, preferably the transmission rail comprises a plurality of second transmission devices connected with each other in turn, and each of the second transmission devices comprising: a fourth support seat mounted on the base; and a transmission chain mounted on the fourth support seat, wherein the storage tray is placed on the transmission chain, so as to move with the transmission chain; and a driving shaft mounted on the fourth support seat, so as to drive the transmission chain to circularly move.

In the above electronic apparatus production system, preferably a retaining device is mounted on the fourth support seat, and the retaining device is configured to slidably retain the storage tray on the fourth support seat.

The above electronic apparatus production system preferably further comprises at least one gantry frame device each comprising: two vertical frames; a lateral beam supported on the two vertical frames and provided with one of the second transmission devices thereon; and two lifting devices mounted on the two vertical frames, respectively, to lift the storage tray, wherein one end of one of the second transmission devices extends into one of the two vertical frames, respectively.

In the above electronic apparatus production system, the transmission rail preferably further comprises a supporting frame having a height substantially equal to that of the base, and some of the fourth support seats are mounted on the second supporting frame.

The above electronic apparatus production system preferably further comprises an auxiliary transmission rail on which an auxiliary tray for carrying the electronic apparatus to be assembled is provided.

In the electronic apparatus production system according to above various preferred embodiments of the present invention, the automatic distributing equipment can place the scattered components on the storage tray in groups and in a regular manner, the automatic assembling equipment can grip the components from the storage tray and assemble these components into the electronic apparatus, and an empty storage tray may move back to the automatic distributing equipment, improving the automation level of manufacturing the electronic apparatus.

### BRIEF DESCRIPTION OF THE DRAWINGS

The above and other features of the present invention will become more apparent by describing in detail preferred embodiments thereof with reference to the accompanying drawings, in which:
Fig.1 is an illustrative perspective view of an electronic apparatus production system according to a preferred embodiment of the present invention;
Fig.2 is an illustrative perspective view of an automatic distributing equipment in the electronic apparatus production system of Fig. 1 according to a preferred embodiment of the present invention;
Fig.3 is another illustrative perspective view of the automatic distributing equipment of Fig.2;
Fig.4 is yet another illustrative perspective view of the automatic distributing equipment of Fig.2, wherein a recognition device is not shown;
Fig.5 is an illustrative partial enlarged view of the automatic distributing equipment of Fig.2;
Fig.6 is an illustrative perspective view of a first transmission device and a storage device matched with the first transmission device in an automatic distributing equipment according to a preferred embodiment of the present invention;
Fig.7 is another illustrative perspective view of the first transmission device and the storage device matched with the first transmission device in an automatic distributing equipment according to a preferred embodiment of the present invention, in which a vibration device and a light source are shown;
Fig.8 is an illustrative perspective view of a first transmission device in an automatic distributing equipment according to a preferred embodiment of the present invention;
Fig.9 is an illustrative cross section view of a second support seat and a horizontal conveyer belt assembly of the first transmission device;
Fig.10 is an illustrative cross section view of a second support seat and an oblique conveyer belt assembly of the first transmission device;
Fig.11 is an illustrative perspective view of a loading device in an automatic distributing equipment according to a preferred embodiment of the present invention;
Fig.12 is an illustrative perspective view of a first robot in an automatic distributing equipment according to an exemplary embodiment of the present invention;
Fig. 13 is an illustrative perspective view of a second transmission device and a storage tray in an electronic apparatus production system according to a preferred embodiment of the present invention;
Fig.14 is an illustrative perspective view of a storage tray in an automatic distributing equipment according to a preferred embodiment of the present invention.
Fig.15 is an illustrative perspective view of a pre-distributing equipment in the electronic apparatus production system of Fig.1;
Fig.16 is an illustrative perspective view of a third robot of the electronic apparatus production system of Fig. 1 in operation;
Fig.17 is an illustrative perspective view of pre-assembling a component on a storage tray by the third robot of Fig.16;
Fig. 18 is an illustrative enlarged view of a portion A shown in Fig. 1;
Fig. 19 is an illustrative perspective view of an automatic assembling equipment in the electronic apparatus production system of Fig.1 when it is assembling an electronic apparatus;
Fig.20 is an illustrative perspective view of a storage tray held on a second transmission device; and
Fig.21 is an illustrative perspective view of a gantry frame device in the electronic apparatus production system of Fig. 1.

### DETAILED DESCRIPTION OF PREFERRED EMBODIMENTS OF THE IVENTION

Preferred embodiments of the present invention will be described hereinafter in detail with reference to the attached drawings, wherein the like reference numerals refer to the like elements.

There is provided an electronic apparatus production system, comprising the features of claim 1

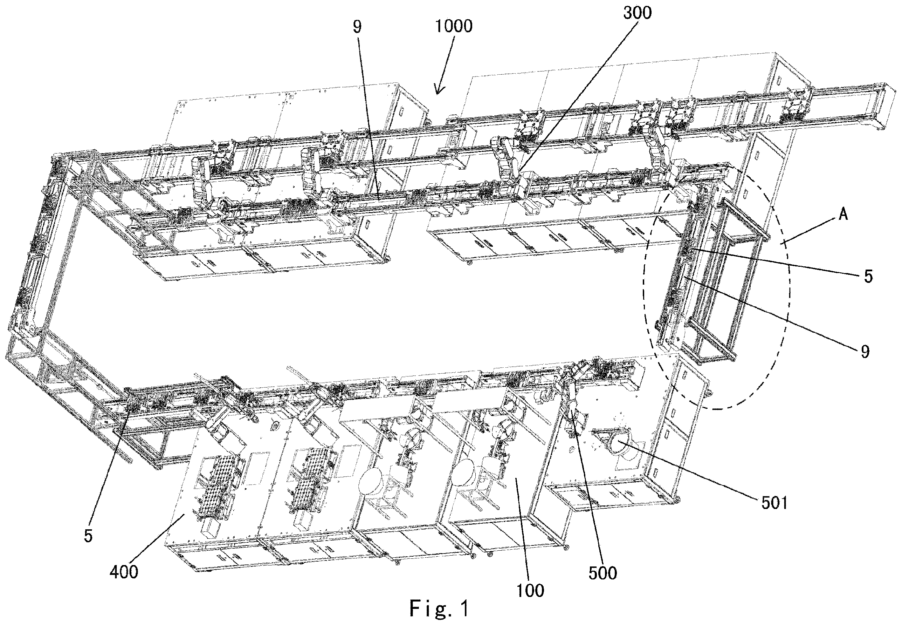

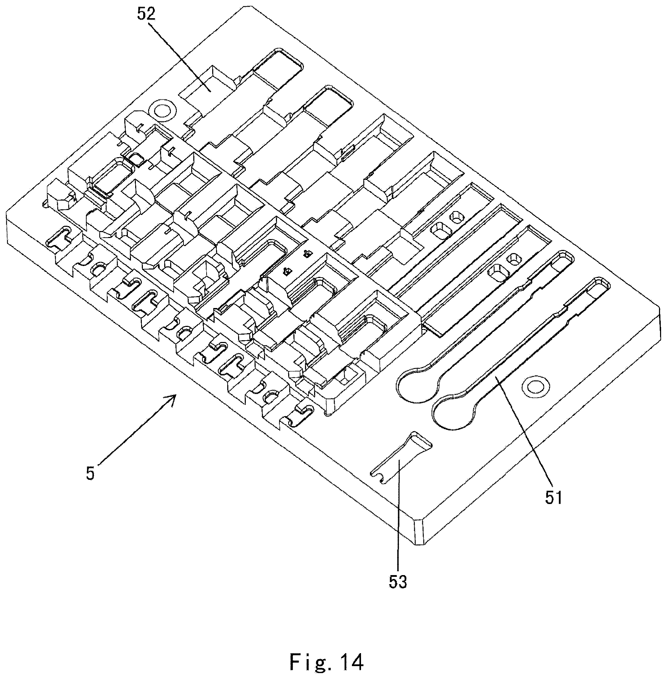

Fig.1 is an illustrative perspective view of an electronic apparatus production system according to a preferred embodiment of the present invention. As shown in Fig.1, in a preferred embodiment of the present invention, the electronic apparatus production system 1000 comprising: a transmission rail 9 in the form of a substantially closed loop; a plurality of storage trays 5 circulating on the transmission rail 9, each of the storage trays 5 comprising a plurality of holding portions 51(Fig. 14) to hold different components 200 with different shapes; at least one automatic distributing equipment 100 configured to mount the different components 200 with different shapes on the respective holding portions 51; and at least one automatic assembling equipment 300 configured to grip the different components 200 with different shapes from the storage tray 5 and assemble the gripped different components with different shapes into an electronic apparatus (not shown).

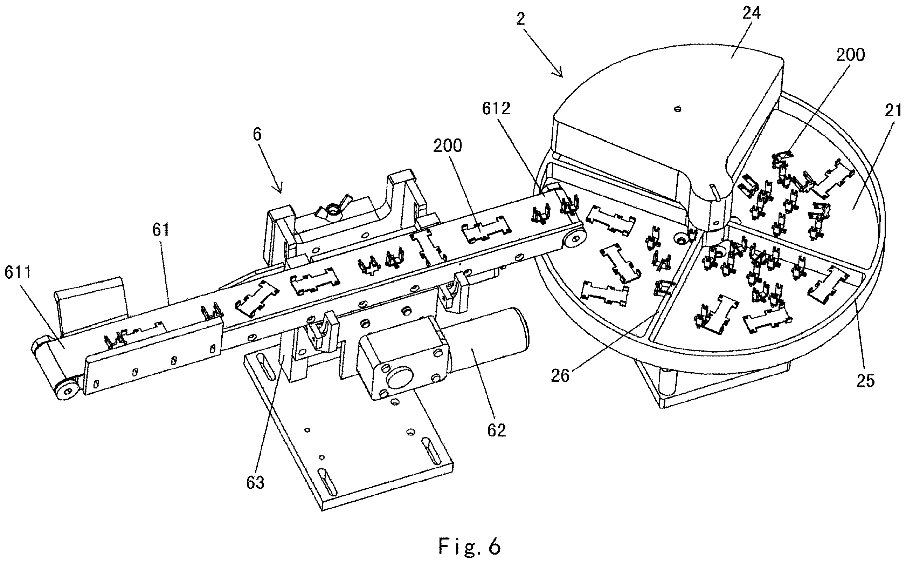

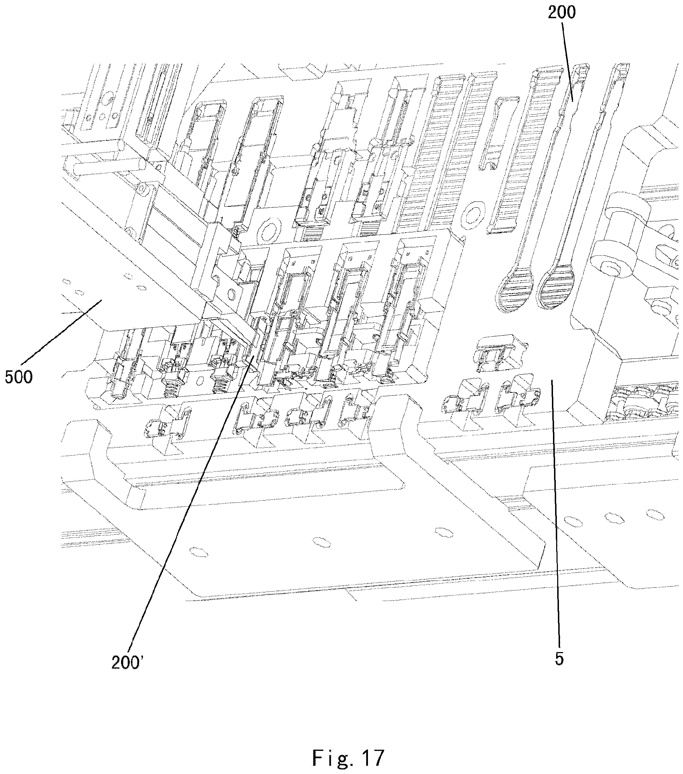

As shown in Figs.6 and 17, in a preferred embodiment of the present invention, the components 200, as objects to be operated, are adapted to be assembled into an electronic apparatus, for example, an electrical connector, a fiber optic connector, a relay or the like, in a subsequent operation process. These components 200 include but not limited to a case, a contact, a spring, a bolt, an insulation block, a wire and the like mixed together. It should be appreciated that these different types of components have different shapes, sizes, flexibilities and functions.

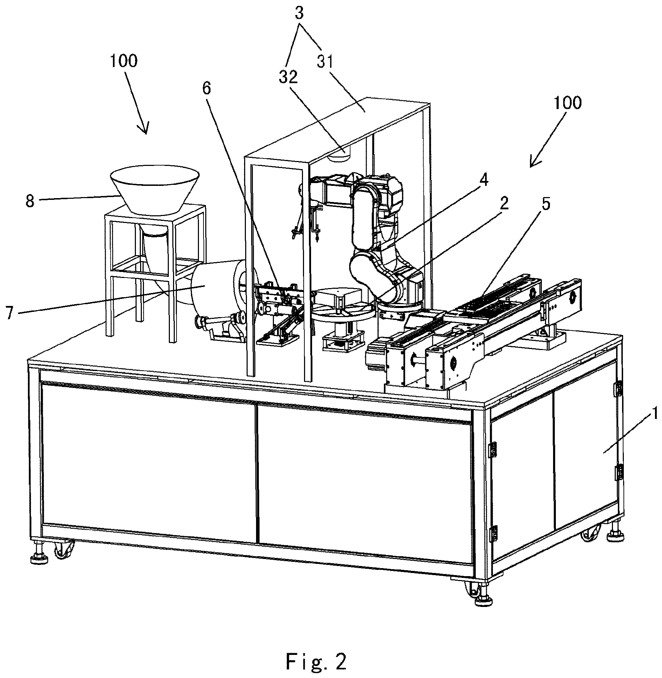

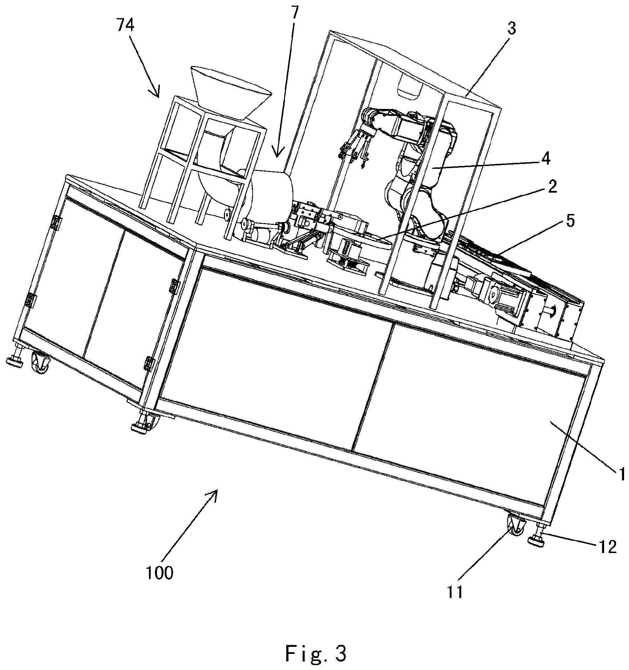

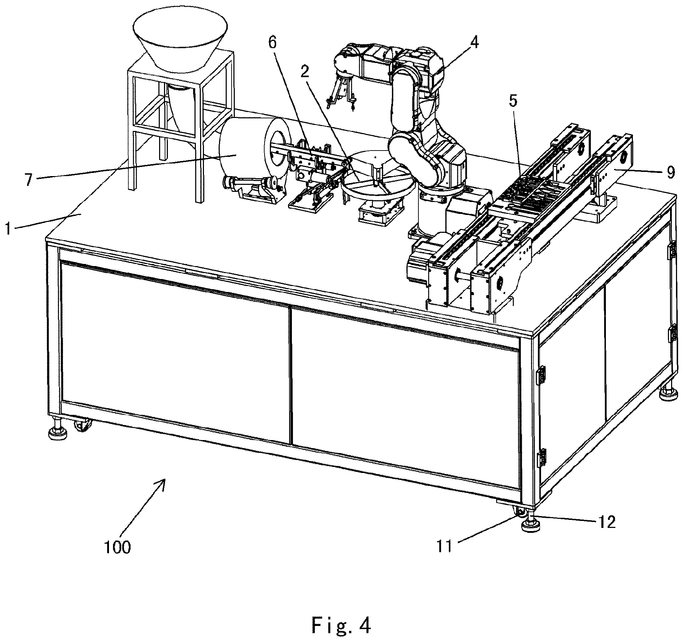

Fig.2 is an illustrative perspective view of an automatic distributing equipment in the electronic apparatus production system of Fig.1; Fig.3 is another illustrative perspective view of the automatic distributing equipment of Fig.2; Fig.4 is yet another illustrative perspective view of the automatic distributing equipment of Fig.2, wherein a recognition device is not shown.

As shown in Figs.2-4, in a preferred embodiment of the present invention, the automatic distributing equipment 100 is configured to distribute a variety of components 200 with different shapes. The automatic distributing equipment 100 comprises a base 1 having, for example, a box shape, a storage device 2, a recognition device 3 and a pickup device 4. The storage device 2 is mounted on the base 1 and configured to store a plurality of components 200. The recognition device 3 is configured to recognize the components 200 stored on the storage device 2, for example, recognize the parameters such as the shape, the size or the weight of the components 200. The pickup device 4 is configured to pick up the recognized components 200 based on a recognition result of the recognition device 3, so as to place the picked components 200 on another preset location.

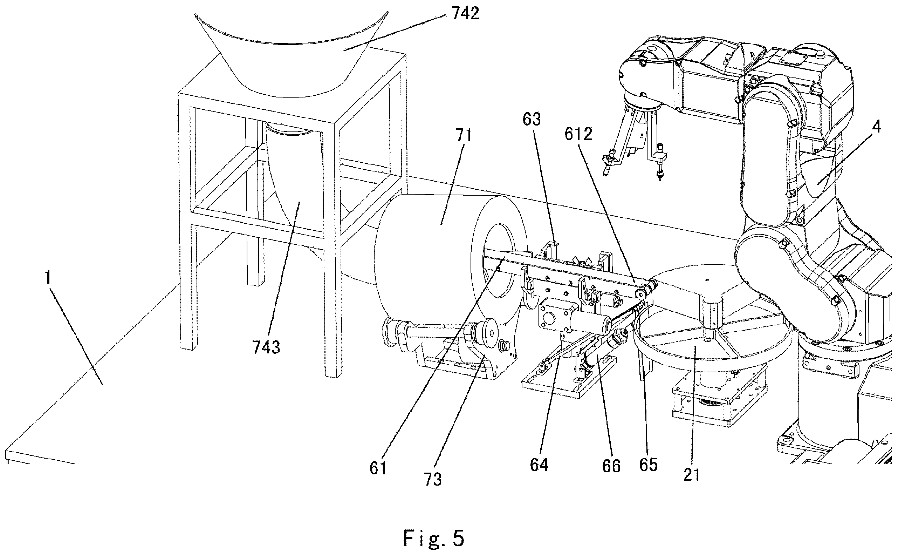

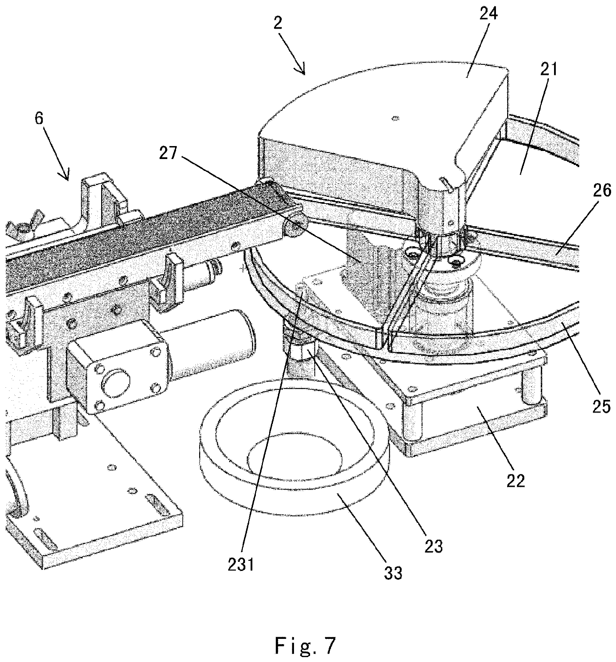

Fig. 5 is an illustrative partial enlarged view of the automatic distributing equipment of Fig.2; Fig.6 is an illustrative perspective view of a first transmission device and a storage device matched with the first transmission device in an automatic distributing equipment according to an exemplary embodiment of the present invention; Fig.7 is another illustrative perspective view of the first transmission device and the storage device matched with the first transmission device in an automatic distributing equipment according to a preferred embodiment of the present invention, in which a vibration device and a light source are shown.

As shown in Figs.5-7, in an automatic distributing equipment 100 according to another preferred embodiment of the present invention, the storage device 2 comprises a support tray 21 configured to place the components 200 thereon and a first support seat 22 mounted on the base 1. The support tray 21 is mounted on the first support seat 22. In an embodiment, the support tray 21 has a substantially circular shape, and an axis of the support tray 21 is perpendicular to a horizontal plane.

In a further preferred embodiment, the storage device 2 further comprises a first motor 27 mounted on the first support seat 22. The first motor 27 is configured to drive the support tray 21 to rotate. A plurality of division plates 26 extending in a radial direction are provided on the support tray 21, so as to divide the support tray 21 into a plurality of storage sections, for example, four storage sections, having a substantially fanlike shape. In this way, one of the storage sections may be used to receive components in a position, and after being rotated by a predetermined angle, for example, 90 degrees, the recognition device 3 recognizes the components, and the pickup device 4 picks up the recognized components.

In another preferred embodiment, a ring-shaped blocking plate 25 is provided on the periphery of the support tray 21, so as to block the components 200 from falling out from an edge of the support tray 21. A fanlike blocking plate 24 is provided on the support tray 21, the fanlike blocking plate 24 is arranged to block the components 200 from bouncing out of the support tray 21 after the components 200 drops onto the support seat 21. It should be appreciated that the fanlike blocking plate 24 does not cover the storage section which is receiving the components.

As shown in Fig.7, in an automatic distributing equipment according to a preferred embodiment of the present invention, the storage device 2 further comprises a vibration device 23 mounted on the base 1 under the support tray 21 and configured to vibrate the support tray 21. In another embodiment, the vibration device 23 vibrates the support tray 21 in a manner of impulse hunting. In an exemplary embodiment, the vibration device 23 comprises a vibration head 231, and an electric excitation mechanism is provided in the vibration device 23. Upon an impulse voltage is exerted, the vibration head 231 may be quickly stretched out or withdrawn, and hit the support tray 21 in the stretched state to vibrate the support tray 21, so as to change the posture of the components 200 on the support tray 21, for example, turn over or rotate the components 200 for facilitating the recognition device 3 to recognize the components 200.

It should be appreciated that the support tray is not limited to have a circular shape, it may have an oval shape, a square shape, a rectangle shape or any other polygon shape, and the support tray may be configured to be unable to rotate.

As shown in Figs.2 and 7, in an automatic distributing equipment according to a preferred embodiment of the present invention, the recognition device 3 comprises: a first support frame 31 mounted on the base 1; and a camera 32, for example, CCD camera 32, mounted on the first support frame 31 and pointed at one storage section on the support tray 21, so as to capture images of the components 200 stored on the storage device 21. The recognition device 3 further comprises a light source 33 configured to illuminate the components 200 stored on the storage device 21. In an exemplary embodiment, the support tray 21 may be made of transparent material, the camera 32 is mounted above the support tray 21, and the light source 33 is mounted below the support tray 21. In this way, it may increase the definition of the components 200, so as to obtain a clear image of the components 200. The image signal of the components 200 obtained by the camera 32 is transferred to a controller (not shown), and the controller analyses and compares the image signal to recognize a position and a type of a certain component 200, and controls the pickup device 4 to pick up the recognized component 200.

In an alternative preferred embodiment, the camera may be mounted below the support tray, and the light source may be mounted above the support tray. In another embodiment, the camera and the light source may be both mounted above or below the support tray.

As shown in Figs.2, 6-10, in a further preferred embodiment of the present invention, the automatic distributing equipment 100 may further comprise a first transmission device 6 configured to transmit the components 200 onto the storage device 2. Further, the first transmission device 6 comprises: a second support seat 63 mounted on the base 1; a conveyer belt assembly 61 mounted on the second support seat 63 in a longitudinal direction and comprising a receiving end 611 for receiving the components 200 and a releasing end 612 for releasing the components 200; and a second motor 62 mounted on the second support seat 63 and configured to drive a conveyer belt 614 of the conveyer belt assembly 61 to move. In this way, the conveyer belt assembly 61 transmits the components 200 received from the receiving end 611 to the releasing end 612, and drops the components 200 onto the support tray 21.

Although it has been described the preferred embodiments of the first transmission device comprising the conveyer belt assembly, but the present invention is not limited to this. In an alternative embodiment, the first transmission device may comprise a conveyer guide rail consisting of a plurality of rolling shafts.

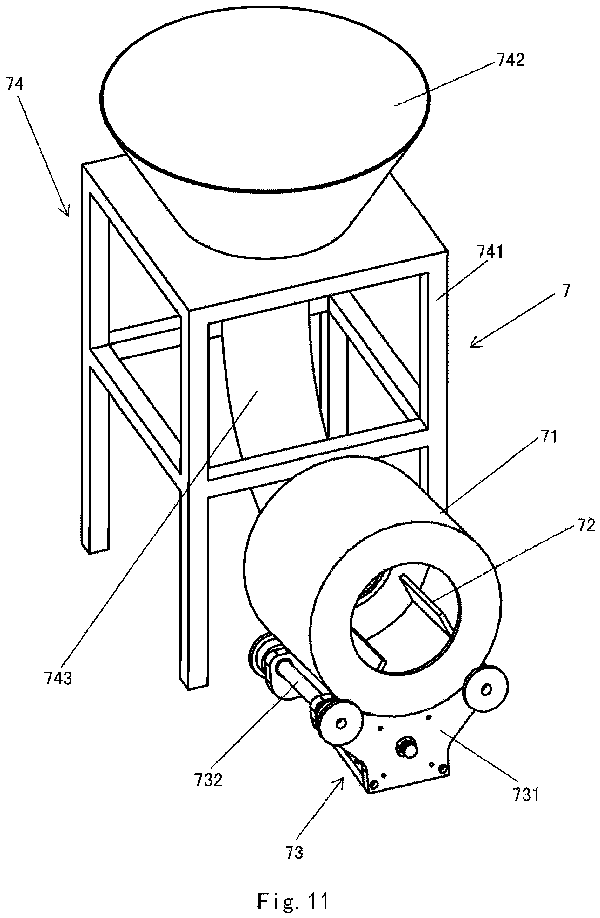

As shown in Figs.2-5 and 11, in a further preferred embodiment of the present invention, the automatic distributing equipment 100 may further comprise a loading device 7 configured to load the components 200 onto the receiving end 611 of the conveyer belt assembly 61. Particularly, the loading device 7 comprises: a rolling drum 71, orientated in a substantially horizontal direction, into which the receiving end 611 of the conveyer belt assembly 61 is inserted in a substantially horizontal direction; a driving device 73 configured to drive the rolling drum 71 to rotate; and at least a scraping plate 72 mounted on an inner wall of the rolling drum 71 in an axial direction.

In a preferred embodiment, a surface of the scraping plate 72 is in the radial direction of the rolling drum 71. In another embodiment, a surface of the scraping plate 72 defines an angle with respect to the radial direction of the rolling drum 71. In this way, when the scraping plate 72 is located at the lowest position, the components is located at the lowest position of the rolling drum 71 under the weight. During rotating the rolling drum 71, some of the components are held on the inner wall of the rolling drum 71 under the push of the scraping plate 72 and rotate with the rolling drum 71. After the rolling drum 71 is rotated by a predetermined angle, for example, an angle larger than 90 degrees, the components drop from the scraping plate 72 onto the receiving end 611 of the conveyer belt assembly 61 under the weight, and are transmitted to the releasing end 612 by the conveyer belt of the conveyer belt assembly 61. With the rotating of the rolling drum 71, the components repeatedly rise and fall in the rolling drum, which may prevent the components from being entangled with each other.

As shown in Figs.2-6 and 11, in an automatic distributing equipment 100 according to a preferred embodiment of the present invention, the loading device 7 further comprises an input device 74 communicated with an inner space of the rolling drum 71 at the other end of the rolling drum opposite to one end of the rolling drum for inserting the receiving end 611 of the conveyer belt assembly 61, so as to input the components into the rolling drum 71. Particularly, the input device 74 comprises: a second support frame 741 mounted on the base 1; a funnel portion 742 supported on the second support frame 741 and configured to receive the components; and a bending portion 743 located under the funnel portion 742 and communicated with the inner space of the rolling drum 71. In this way, the components input into the funnel portion 742 may slide down and enter the rolling drum 71 through the bending portion 743 under the weight.

In another preferred embodiment, the driving device 73 comprises: a third support seat 731 mounted on the base 1; a third motor (not shown) mounted on the third support seat 731; and a plurality of rolling shafts 732 mounted on the third support seat and rotatably engaged with an outer surface of the rolling drum 71, so as to rotate the rolling drum 71 under the driving of the third motor. During rotating the rolling drum 71, some of the components are raised by the scraping plate 72 and fall down onto the conveyer belt 614 of the conveyer belt assembly 61.

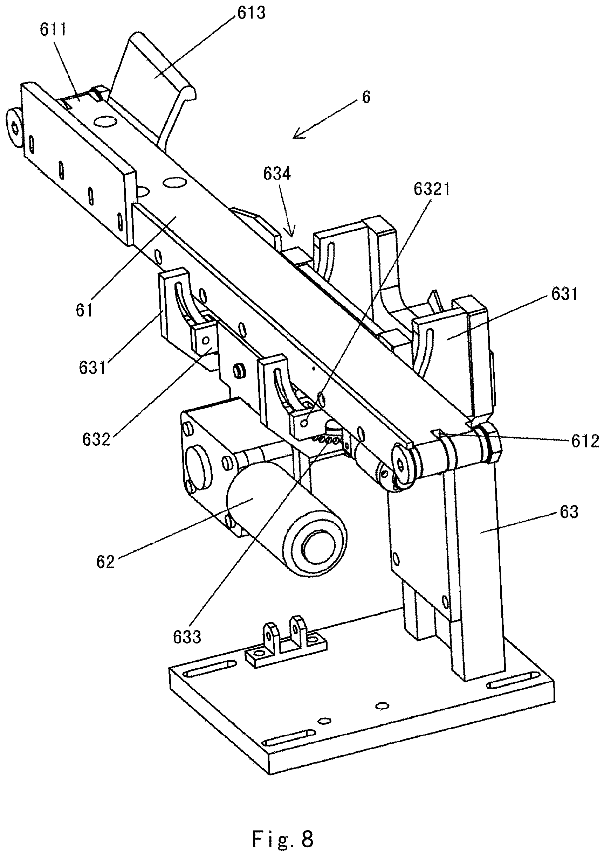

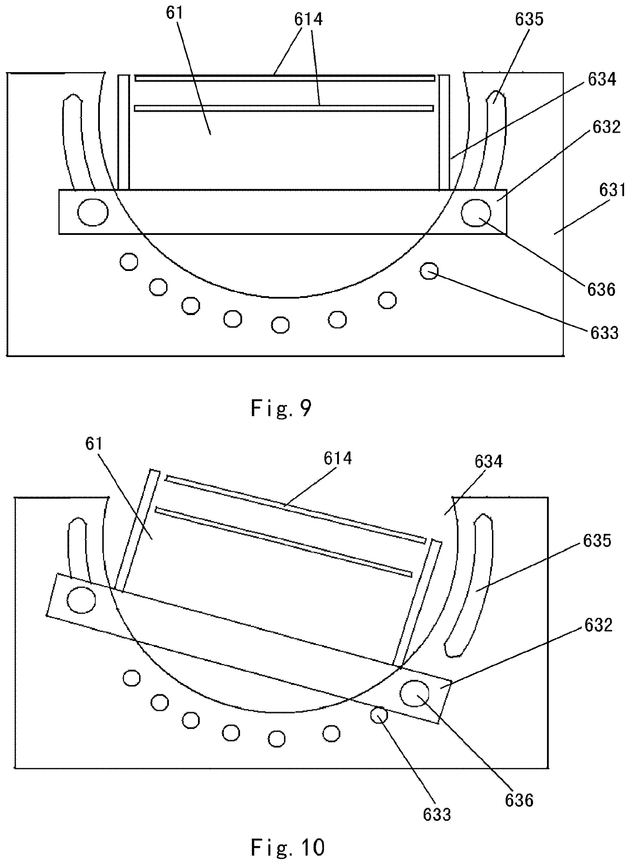

As shown in Figs.8-10, in an automatic distributing equipment 100 according to a preferred embodiment of the present invention, an angle of a surface of the conveyer belt assembly 61 with respect to a horizontal plane is adjustable in a lateral direction (the left and right direction in Fig. 9 and 10) perpendicular to a transmitting direction of the conveyer belt. Particularly, the second support seat 63 comprises at least two arcuate brackets 631 each comprising: an arcuate groove 634; a plurality of through holes 633 arranged in an arcuate shape along the periphery of the arcuate groove 634; and a lateral bracket 632 on which the conveyer belt assembly 61 is mounted. Both ends of the lateral bracket 632 are selectively engaged in two through holes of the plurality of through holes 633 by, for example, bolts, so that the lateral bracket 632 strides on a portion of the arcuate groove 634 in a changeable posture. In order to facilitate the operation, the through holes comprise a slot 635 formed at both sides of the arcuate groove 634.

As shown in Fig.9, both ends of the lateral bracket 632 are mounted in two slots 635 in the horizontal plane by means of bolts 636, so that the lateral bracket 632 is orientated in the horizontal direction. As shown in Fig.10, one end (left end) of the lateral bracket 632 is mounted in the slot 635 by a bolt 636, and the other end (right end) of the lateral bracket 632 is mounted in the through hole 633 by a bolt 636, so that the surface of the lateral bracket 632 is oblique with respect to the horizontal plane in the lateral direction perpendicular to the transmitting direction of the conveyer belt. It should be appreciated that the posture of the lateral bracket 632 is changeable by mounting the two ends of the lateral bracket 632 in different through holes. In this way, by obliquely mounting the lateral bracket 632, it may prevent the components on the conveyer belt assembly 61 from being stacked on the receiving end 611, and prevent the components from falling outside the rolling drum 71 from the conveyer belt 614 before arriving at the releasing end 612 during transmitting the components by the conveyer belt 614. It may also be possible to adjust the number of the components transmitted from the rolling drum 71 to the storage device 5 by changing the obliquity of the lateral bracket 632.

In addition, at least one side of the receiving end 611 of the conveyer belt assembly 61 in a lateral direction is provided with a blocking plate 613, so as to prevent the components, falling onto the receiving end 611 from the scraping plate 72, from falling into the rolling drum 71 due to bounce.

As shown in Fig.5, a guide device is provided under the releasing end 612 of the conveyer belt assembly 61, and the guide device is configured to guide the components from the conveyer belt assembly 61 toward the support tray 21 of the storage device 2. Particularly, the guide device comprises: a plurality of support rods 64 pivotally mounted on the second support seat 63; and a guide plate 65 mounted on upper ends of the support rods 64 and obliquely extending from the lower portion of the releasing end 612 to the storage device 2, so as to guide the components to slide along the guide plate 65 from the releasing end 612 to the storage device 2, decreasing the tendency of the components to fall out of the storage device due to bounce. In another embodiment, the support rod comprises at least one telescoping rod 66.

As shown in Figs.2-4 and 12, in an automatic distributing equipment 100 according to a preferred embodiment of the present invention, the pickup device 4 is a first robot and comprises a plurality of grippers 41-43 adapted to pick up the components with different shapes. In an embodiment, the first robot includes but not limited to four-axis robot, six-axis robot or any other type of robot with multiple degrees of freedom. The first robot may recognize the images of the components captured by the camera 32 according to a preset program, so as to control the grippers 41-43 to grip the respective components.

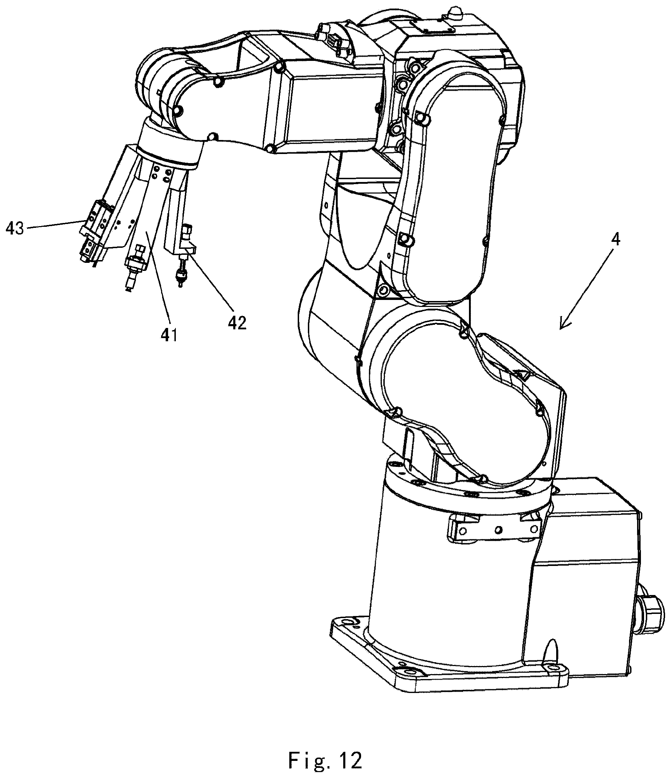

For instance, as shown in Fig.12, the gripper 41 has a large sucking disc adapted to grip a contact, the gripper 42 has a small sucking disc adapted to grip a wire, the gripper 42 has a plurality of arms adapted to grip a large component, for example, a case of the electrical connector. One or more different types of grippers may be mounted on the robot according to actual requirements.

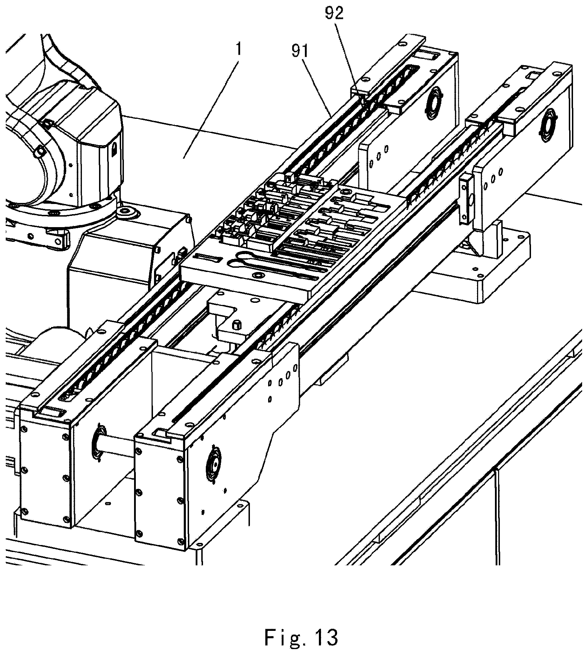

As shown in Figs. 13 and 14, according to a preferred embodiment of the present invention, the automatic distributing equipment 100 further comprises a storage tray 5. The storage tray 5 comprises a plurality of holding portions 51-53 configured to hold components with different shapes. For example, the holding portion 51 is configured to hold the contact, the holding portion 52 is configured to hold a connector case, and the holding portion 53 is configured to hold a spring. For example, the holding portion is formed with a recess, and the recess is shaped to match with the external contour of the respective component, so that the component held in the holding portion 51 unlikely moves and falls out due to vibration. The robot, as the pickup device 4, is further configured to place the picked components 200 on the respective holding portions of the storage tray 5 according to a preset program. For example, a group or a plurality of groups of components for assembling one or more electrical connectors are placed on each storage tray 5, so as to assemble these components into the electrical connector in a subsequent operation process.

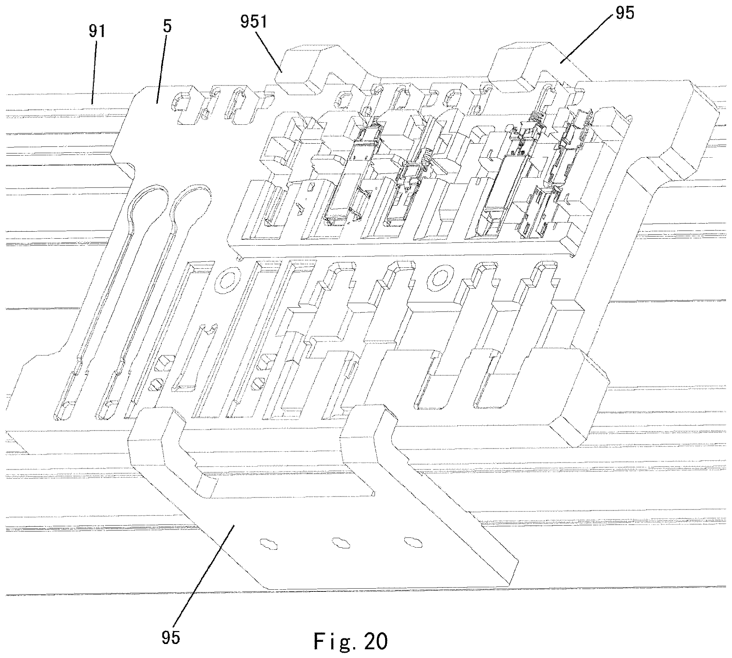

As shown in Figs.13, 18 and 20, in an automatic distributing equipment 100 according to a preferred embodiment of the present invention, the transmission rail 9 comprises a plurality of second transmission devices. Each of the second transmission device comprises: a fourth support seat 91 mounted on the base 1; a transmission chain 92 mounted on the fourth support seat 91, the storage tray 5 is placed on the transmission chain 92 and is moved onto next worktable with the transmission chain 92; and a driving shaft 94 mounted on the fourth support seat 91, so as to drive the transmission chain 92 to circularly move. In an embodiment, a retaining device 95 is mounted on the fourth support seat 91, and the retaining device 95 is configured to slidably retain the storage tray 5 on the fourth support seat 91.

In a preferred embodiment, the retaining device 95 is mounted both sides of the fourth support seat 91 in a lateral direction perpendicular to a movement direction of the storage tray 5 and extends above the fourth support seat 91. In an embodiment, a bending portion 951 extending inward is provided on a distal end of the retaining device 95. With this configuration, it may prevent the storage tray 5 from leaving from the fourth support seat 91 during operating the storage tray 5 (for example, during mounting/removing the components on/from the storage tray).

As shown in Figs.2-4, in a preferred embodiment, the base 1 comprises: a plurality of wheels 11 mounted on a bottom of the base 1; and a plurality of support legs 12 telescopically mounted on the bottom of the base 1. The storage device 2, the recognition device 3, the pickup device 4, the support tray 5, the first transmission device 6, the second transmission device 54 and the loading device 7 may be all mounted on the base 1. In this way, it may push the base 1 to move by the wheels 11, so as to move the automatic distributing equipment 100 according to embodiments of the present invention to a right position. When the automatic distributing equipment 100 is moved to the right position, the support legs 12 may be stretched out to suspend the wheels 11, increasing the support strength of the base, and preventing the base 1 from being moved. According to actual requirements, it may be possible to mount one or more of the storage device 2, the recognition device 3, the pickup device 4, the support tray 5, the first transmission device 6, the second transmission device 54 and the loading device 7 on the base 1.

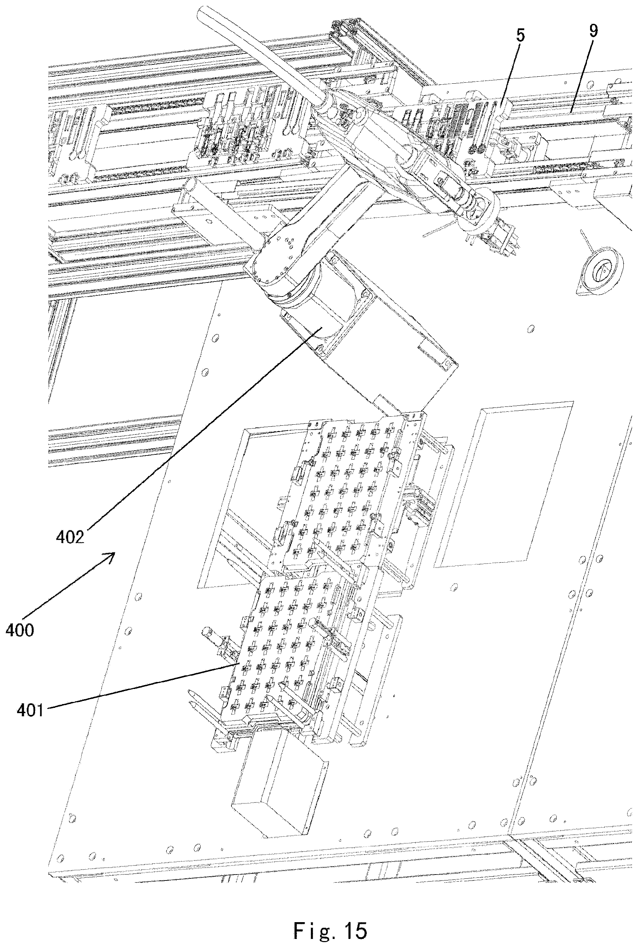

As shown in Figs.1 and 15, in a preferred embodiment of the present invention, the electronic apparatus production system 1000 further comprises at least one pre-distributing equipment 400 each comprising: at least one distributing disk 401 on each of which a plurality of single type of components, for example, contacts, springs or the like, are pre-placed; and a second robot 402 configured to grip the components from the distributing disk 401 and mount the gripped components on the storage tray 5. In this way, it may be possible to use the pre-distributing equipment 400 to mount some pre-grouped components on the storage tray 5. It should be appreciated that the pre-distributing equipment 400 may be omitted herein.

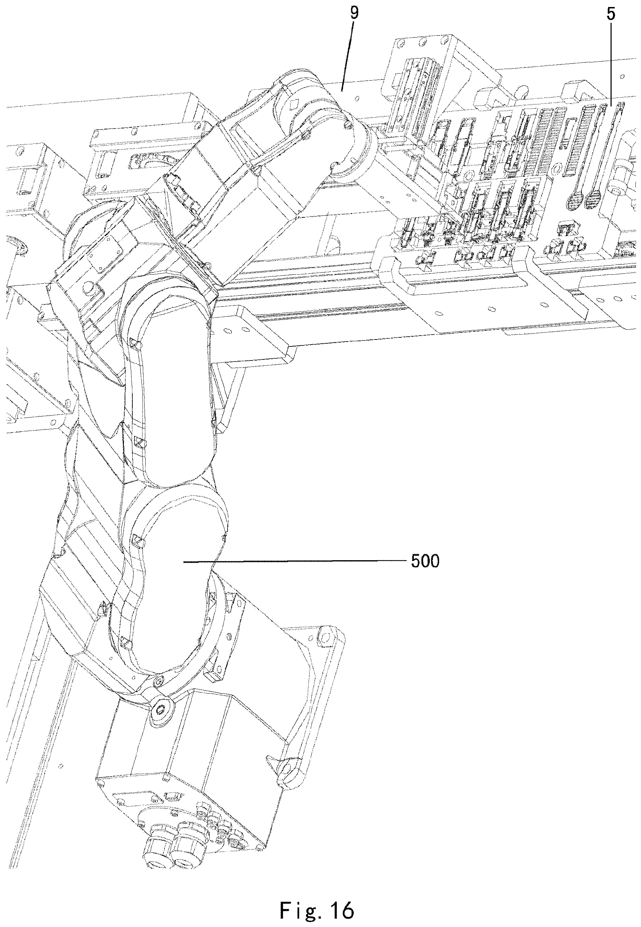

As shown in Figs.1, 16 and 17, in a preferred embodiment of the present invention, the electronic apparatus production system 1000 further comprises at least one third robot 500 mounted at downstream of the automatic distributing equipment in a moving direction of the storage tray, each of the at least one third robot 500 is configured to pre-assemble some of the components mounted on the storage tray. For example, the third robot picks up a metal sheet 201' of an electronic apparatus from a container 501 (see Fig.1) and pre-assemble it on a support frame mounted on the holding portion of the storage tray. In this way, it may reduce the subsequent operation processes. It should be appreciated that the third robot 500 may be omitted herein.

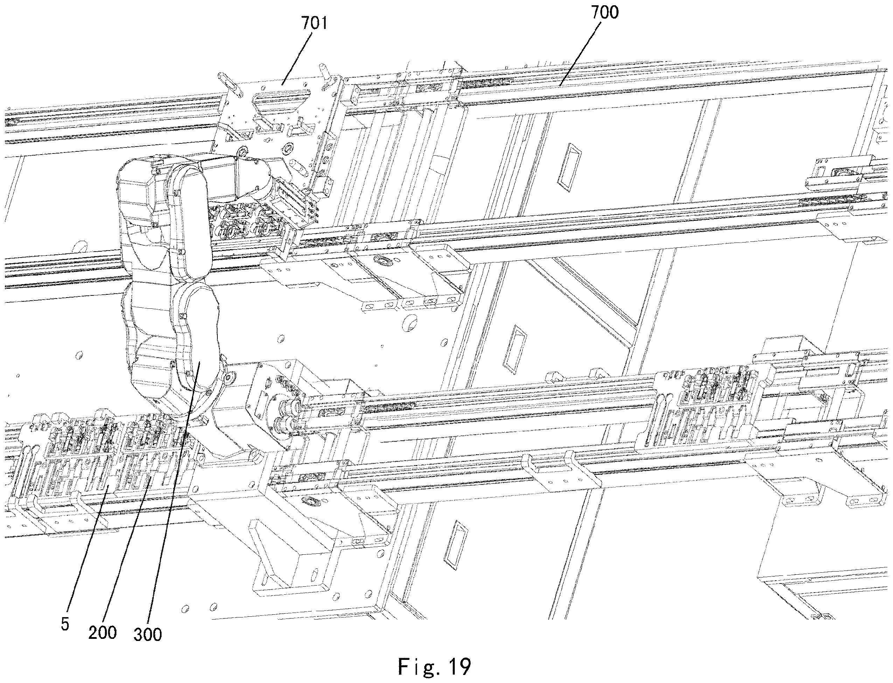

As shown in Figs.1 and 19, the automatic assembling equipment 300 comprises a fourth robot configured to grip the respective components 200 at a predetermined location on the storage tray 5, on which various components 200 are placed, and assemble the picked components into the electronic apparatus according to a program pre-stored in the fourth robot.

As shown in Figs.1 and 19, in a preferred embodiment of the present invention, the electronic apparatus production system 1000 further comprises an auxiliary transmission rail 700 on which an auxiliary tray 701 for carrying the electronic apparatus to be assembled is provided. The auxiliary tray 701 may move on the auxiliary transmission rail 700. In this way, the assembled electronic apparatus may be transmitted to a preset position by means of the auxiliary tray 701, so as to perform further operations, for example, testing, packaging or the like.

In an preferred embodiment of the present invention, the above robots include but not limited to four-axis robot, six-axis robot or any other type of robot with multiple degrees of freedom. These robots may recognize the components according to preset programs, so as to control the grippers to grip the respective components, and mount the gripped components on predetermined positions. As for the configuration of the robot, since it belongs to prior art, its detailed description is omitted herein.

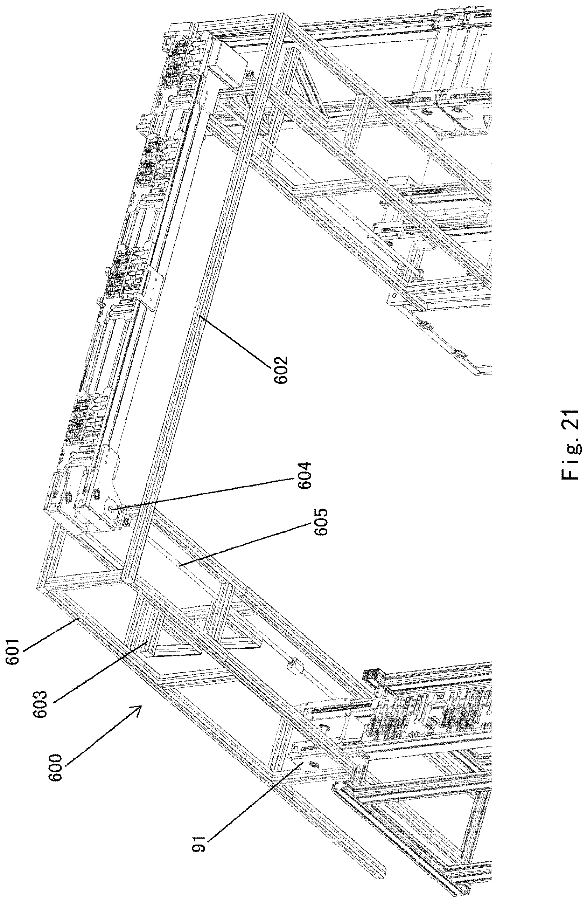

As shown in Figs.1 and 21, in a preferred embodiment of the present invention, the electronic apparatus production system 1000 further comprises at least one gantry frame device 600 each comprising: two vertical frames 601, one end of the fourth support seat 91 in one of the second transmission devices extends into one of the two vertical frames, respectively; a lateral beam 602 supported on the two vertical frames 601 and provided with another second transmission device thereon; and two lifting devices 603 mounted in the two vertical frames 601, respectively, to lift the storage tray 5.

In an preferred embodiment, a driving motor 604 is provided in the second transmission device mounted on the lateral beam 602. The driving motor 604 is connected to the lifting device 603 via a cable 605. The driving motor 604 may drive the lifting device 603 up and down by means of the cable 605. The storage tray 5 moved to the end of the fourth support seat 91 may be further moved onto the lifting device 603 flush with the fourth support seat 91 under the driving of the transmission chain. Then, the driving motor 604 drives the lifting device 603 to rise, so as to lift the storage tray to a level flush with the second transmission device on the lateral beam 602, and then drive the storage tray to move onto the second transmission device on the lateral beam 602. Thereafter, the storage tray 5 is lift down in the other vertical frame 601 and moved onto another second transmission device. In this way, it achieves a discontinuous circulating movement of the storage tray. Generally, the gantry frame device has a height substantially same as that of an operator, for facilitating the operator to enter the electronic apparatus production system.

It should be appreciated that a rotation device and a driving mechanism may be provided on the lifting device 603. The rotation device is configured to rotate the storage tray 5 moved onto the lifting device 603 by an angle of about 90 degrees, and the driving mechanism is configured to push the storage tray 5, moved onto the lifting device 603 flush with the second transmission device on the lateral beam 602, onto the second transmission device on the lateral beam 602, so that the storage tray continues to move on the second transmission device on the lateral beam 602. Similarly, a similar rotation device and a similar driving mechanism may be provided at a joint of the other two second transmission devices perpendicular to each other, so as to rotate the storage tray 5 by an angle of about 90 degrees, and push the storage tray 5 onto a next second transmission device. By means of the rotation device and the driving mechanism, the storage tray may be smoothly transmitted between two second transmission devices perpendicular to each other.

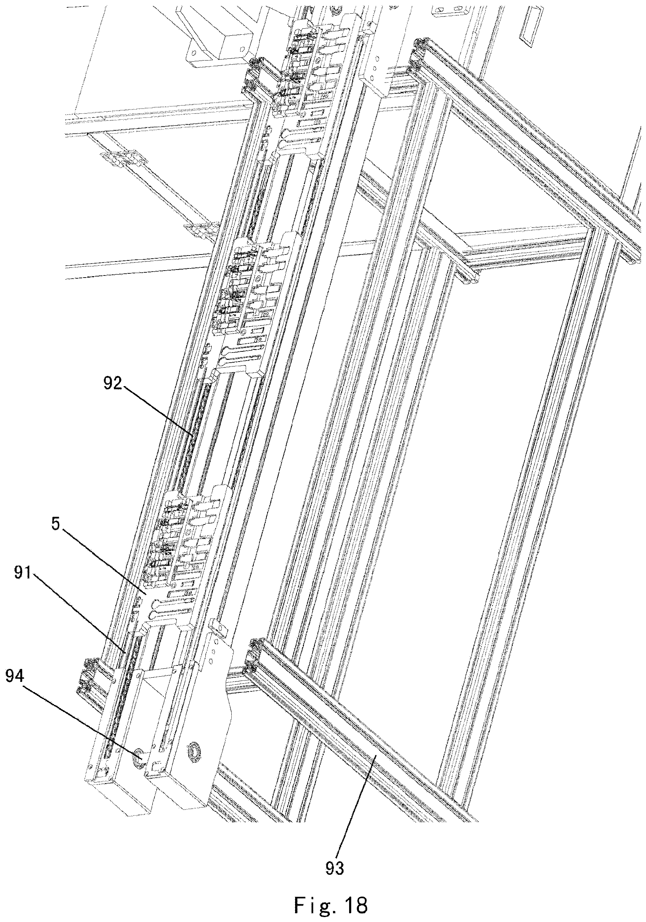

In another preferred embodiment, as shown in Figs.1 and 18, the transmission rail 9 further comprises a supporting frame 93. The supporting frame 93 has a height substantially same as that of the base 1. A portion of the fourth support seat 91 is mounted on the supporting frame 93. The supporting frame 93 may support the transmission rail 9 between bases for different robots, so as to achieve a smooth transition of the transmission rail 9 between the bases for different robots. In various embodiments of the present invention, the second transmission devices, except the second transmission device at the gantry frame device, are substantially located in the same horizontal plane, so as to achieve a smooth transition and connection between adjacent second transmission devices.

In the electronic apparatus production system according to above various preferred embodiments of the present invention, the automatic distributing equipment may place the scattered components on the storage tray in groups and in a regular manner, the automatic assembling equipment may grip the components from the storage tray and assemble these components into the electronic apparatus, and an empty storage tray may move back to the automatic distributing equipment, improving the automation level of manufacturing the electronic apparatus.

The automatic distributing equipment, according to above preferred embodiments of the present invention, may recognize components to be distributed, pick up the components based on a recognition result, and regularly place the picked components on the storage tray, so as to prepare components of an electronic apparatus to be assembled in advance, increasing the automation level of manufacturing the electronic apparatus. From the funnel portion to the storage device, the respective devices continuously operate, which will not cause the entire assembling line stopped due to lack of the initially supplied components.

## Claims

1. An electronic apparatus production system (1000) configured to assemble scattered different components (200) with different shapes into an electronic apparatus, comprising:
a transmission rail (9) in the form of a substantially closed loop;
a plurality of storage trays (5) circulating on the transmission rail (9), each of the storage trays (5) comprising a plurality of holding portions (51, 52, 53) to hold the different components (200) with different shapes;
at least one automatic distributing equipment (100) configured to mount the different components (200) with different shapes on the respective holding portions (51, 52, 53); and
at least one automatic assembling equipment (300) configured to grip the different components (200) with different shapes from the storage tray (5) wherein the automatic distributing equipment (100) comprises:
a base (1);
a storage device (2) mounted on the base (1) and configured to store the
plurality of scattered, different components (200) with different shapes;
a recognition device (3) configured to recognize the different components (200) with different shapes placed on the storage device (2); and
a pickup device (4) configured to pick up the recognized different components (200) with different shapes and place the picked different components (200) with different shapes on the respective holding portions (51, 52, 53) of the storage tray (5) according to a recognition result of the recognition device (3).

2. The electronic apparatus production system (1000) according to claim 1, wherein the storage device (2) comprises a support tray (21) configured to place the plurality of scattered, different components (200) with different shape, wherein the storage device (2) further comprises a first support seat (22) mounted on the base (1), and
wherein the support tray (21) is mounted on the first support seat (22) wherein the support tray (21) has a substantially circular shape, and
wherein the storage device (2) further comprises a first motor (27) mounted on the first support seat (22), and the first motor (27) is configured to drive the support tray (21) to rotate.

3. The electronic apparatus production system (1000) according to claim 2,
wherein a plurality of division plates (26) extending in a radial direction are provided on the support tray (21), so as to divide the support tray (21) into a plurality of storage sections having a substantially fanlike shape.

4. The electronic apparatus production system (1000) according to one of claims 2 or 3 wherein a ring-shaped blocking plate (25) is provided on the periphery of the support tray (21), so as to block the components (200) from falling out of the support tray (21).

5. The electronic apparatus production system (1000) according to one of claims 2 to 4, wherein a fanlike blocking plate (24) is provided on the support tray (21), so as to block the components (200) from falling out of the support tray (21).

6. The electronic apparatus production system (1000) according to any one of claims 1 to 5, wherein the automatic distributing equipment (100) further comprising:
a first transmission device (6) configured to transmit the different components (200) onto the storage device (2) wherein the first transmission device (6) comprising:
a second support seat (63) mounted on the base (1);
a conveyer belt assembly (61) mounted on the second support seat (63) and comprising a receiving end (611) for receiving the components (200) and a releasing end (612) for releasing the components (200); and
a second motor (62) mounted on the second support seat (63) and configured to drive a conveyer belt (614) of the conveyer belt assembly (61) to move, wherein the automatic distributing equipment (100) further comprising:
a loading device (7) configured to load the components (200) onto the receiving end (611) of the conveyer belt assembly (61), wherein the loading device (7) comprising:
a rolling drum (71), orientated in a substantially horizontal direction, into which the receiving end (611) of the conveyer belt assembly (61) is inserted in a substantially horizontal direction;
a driving device (73) configured to drive the rolling drum (71) to rotate; and
at least a scraping plate (72) mounted on an inner wall of the rolling drum (71) in an axial direction.

7. The electronic apparatus production system (1000) according to claim 6, wherein the loading device (7) further comprising:
an input device (74) communicated with an inner space of the rolling drum (71) at the other end of the rolling drum (71) opposite to one end of the rolling drum (71) for inserting the receiving end (611) of the conveyer belt assembly (61), so as to input the components (200) into the rolling drum (71).

8. The electronic apparatus production system (1000) according to any one of claims 6 or 7,
wherein an angle of a surface of the conveyer belt assembly (61) with respect to a horizontal plane is adjustable in a lateral direction perpendicular to a transmitting direction of the conveyer belt (614).

9. The electronic apparatus production system (1000) according to claim 8, wherein the second support seat (63) comprises at least two arcuate brackets (631) each comprising:
an arcuate groove (634);
a plurality of through holes (633) arranged in an arcuate shape along the periphery of the arcuate groove (634); and
a lateral bracket (632) on which the conveyer belt assembly (61) is mounted,
wherein both ends of the lateral bracket (632) are selectively engaged in two through holes (633) of the plurality of through holes (633), so that the lateral bracket (632) strides on a portion of the arcuate groove (634) in a changeable posture.

10. The electronic apparatus production system (1000) according to one of claims 1 to 9, further comprising at least one pre-distributing equipment (400) each comprising:
at least one distributing disk (401) on each of which a plurality of single type of components (200) are pre-placed; and
a second robot configured to grip the components (200) from the distributing disk (401) and mount the gripped components (200) on the storage tray (5).

11. The electronic apparatus production system (1000) according to any one of claims 1-10, wherein the transmission rail (9) comprising a plurality of second transmission devices (54) connected in turn, and each of the second transmission devices (54) comprising:
a fourth support seat (91) mounted on the base (1); and
a transmission chain (92) mounted on the fourth support seat (91), wherein the storage tray (5) is placed on the transmission chain (92), so as to move with the transmission chain (92); and
a driving shaft (94) mounted on the fourth support seat (91), so as to drive the transmission chain (92) to circularly move, wherein a retaining device (95) is mounted on the fourth support seat (91), and the retaining device (95) is configured to slidably retain the storage tray (5) on the fourth support seat (91).

12. The electronic apparatus production system (1000) according to one of claims 1 to 11, wherein the recognition device (3) is configured to recognize the type of component (200) placed on the storage device (2).

## Patentansprüche

1. System (1000) für Herstellung elektronischer Vorrichtungen, das so konfiguriert ist, dass es verschiedene lose Komponenten (200) mit verschiedenen Formen zu einer elektronischen Vorrichtung zusammensetzt, wobei es umfasst:
eine Übertragungsschiene (9) in Form einer im Wesentlichen geschlossenen Schleife;
eine Vielzahl auf der Übertragungsschiene (9) umlaufender Aufbewahrungskassetten (5), wobei jede der Aufbewahrungskassetten (5) eine Vielzahl von Aufnahmeabschnitten (51, 52, 53) zum Aufnehmen der verschiedenen Komponenten (200) mit verschiedenen Formen umfasst;
wenigstens eine automatische Verteileinrichtung (100), die so konfiguriert ist, dass sie die verschiedenen Komponenten (200) mit verschiedenen Formen in die jeweiligen Aufnahmeabschnitte (51, 52, 53) einlegt; und
wenigstens eine automatische Montagevorrichtung (300), die so konfiguriert ist, dass sie die verschiedenen Komponenten (200) mit verschiedenen Formen aus der Aufbewahrungskassette (5) entnimmt, wobei die automatische Verteileinrichtung (100) umfasst:
einen Untersatz (1);
eine Aufbewahrungseinrichtung (2), die auf dem Untersatz (1) montiert und so konfiguriert ist, dass sie die Vielzahl verschiedener loser Komponenten (200) mit verschiedenen Formen aufbewahrt;
eine Erkennungseinrichtung (3), die so konfiguriert ist, dass sie die auf die Aufbewahrungseinrichtung (2) aufgelegten verschiedenen Komponenten (200) mit verschiedenen Formen erkennt; und
eine Aufnahmeeinrichtung (4), die so konfiguriert ist, dass sie die erkannten verschiedenen Komponenten (200) mit verschiedenen Formen aufnimmt und die aufgenommenen verschiedenen Komponenten (200) mit verschiedenen Formen entsprechend einem Erkennungsergebnis der Erkennungseinrichtung (3) in den jeweiligen Aufnahmeabschnitten (51, 52, 53) der Aufbewahrungskassette (5) ablegt.

2. System (1000) für Herstellung elektronischer Vorrichtungen nach Anspruch 1, wobei die Aufbewahrungseinrichtung (2) ein Ablagefach (21) umfasst, das zum Auflegen der Vielzahl loser verschiedener Komponenten (200) mit verschiedener Form konfiguriert ist, wobei die Aufbewahrungseinrichtung (2) des Weiteren eine erste Trageauflage (22) umfasst, die auf dem Untersatz (1) montiert ist, und
wobei das Ablagefach (21) auf der ersten Trageauflage (22) montiert ist, und das Ablagefach (21) im Wesentlichen kreisförmig ist, und
wobei die Aufbewahrungseinrichtung (2) des Weiteren einen ersten Motor (27) umfasst, der an der ersten Trageauflage (22) installiert ist, und der erste Motor (27) so konfiguriert ist, dass er das Ablagefach (21) rotierend antreibt.

3. System (1000) für Herstellung elektronischer Vorrichtungen nach Anspruch 2,
wobei eine Vielzahl von Trennplatten (26), die sich in einer radialen Richtung erstrecken, in dem Ablagefach (21) vorhanden sind und das Ablagefach (21) in eine Vielzahl von Aufbewahrungsabschnitten mit einer im Wesentlichen fächerartigen Form unterteilen.

4. System (1000) für Herstellung elektronischer Vorrichtungen nach einem der Ansprüche 2 oder 3,
wobei eine ringförmige Sperrplatte (25) an dem Umfang des Ablagefachs (21) vorhanden ist, um die Komponenten (200) am Herausfallen aus dem Ablagefach (21) zu hindern.

5. System (1000) für Herstellung elektronischer Vorrichtungen nach einem der Ansprüche 2 bis 4,
wobei eine fächerartige Sperrplatte (24) an dem Ablagefach (21) vorhanden ist, um die Komponenten (200) am Herausfallen aus dem Ablagefach (21) zu hindern.

6. System (1000) für Herstellung elektronischer Vorrichtungen nach einem der Ansprüche 1 bis 5, wobei die automatische Verteileinrichtung (100) des Weiteren umfasst:
eine erste Übertragungseinrichtung (6), die so konfiguriert ist, dass sie die verschiedenen Komponenten (200) zu der Aufbewahrungseinrichtung (2) überträgt, wobei die erste Übertragungseinrichtung (6) umfasst:
eine zweite Trageauflage (63), die auf dem Untersatz (1) montiert ist;
eine Förderband-Anordnung (81), die an der zweiten Trageauflage (63) installiert ist und ein Aufnahme-Ende (611) zum Aufnehmen der Komponenten (200) sowie ein Abgabe-Ende (612) zum Abgeben der Komponenten (200) umfasst; und
einen zweiten Motor (62), der an der zweiten Trageauflage (63) installiert und so konfiguriert ist, dass er ein Förderband (614) der Förderband-Anordnung (61) zur Bewegung antreibt, wobei die automatische Verteileinrichtung (100) des Weiteren umfasst:
eine Auflegeeinrichtung (7), die so ausgeführt ist, dass sie die Komponenten (200) auf das Aufnahme-Ende (611) der Förderband-Anordnung (61) auflegt, wobei die Auflegeeinrichtung (7) umfasst:
eine Rolltrommel (71), die in einer im Wesentlichen horizontalen Richtung ausgerichtet ist, in die das Aufnahme-Ende (611) der Förderband-Anordnung (61) in einer im Wesentlichen horizontalen Richtung eingeführt ist;
eine Antriebsvorrichtung (73), die zum rotierenden Antreiben der Rolltrommel (71) konfiguriert ist; und
wenigstens eine Abstreifplatte (72), die an einer Innenwand der Rolltrommel (71) in einer axialen Richtung montiert ist.

7. System (1000) für Herstellung elektronischer Vorrichtungen nach Anspruch 6, wobei die Auflegeeinrichtung (7) des Weiteren umfasst:
eine Einleiteinrichtung (74), die mit einem Innenraum der Rolltrommel (71) an dem anderen, dem einen Ende der Rolltrommel (71) zum Einführen des Aufnahme-Endes (611) der Förderband-Anordnung (61) gegenüberliegenden Ende der Rolltrommel (71) zum Einleiten der Komponenten (200) in die Rolltrommel (71) in Verbindung steht.

8. System (1000) für Herstellung elektronischer Vorrichtungen nach einem der Ansprüche 6 oder 7,
wobei ein Winkel einer Oberfläche der Förderband-Anordnung (61) in Bezug auf eine horizontale Ebene in einer seitlichen Richtung senkrecht zu einer Übertragungsrichtung des Förderbandes (614) verstellt werden kann.

9. System (1000) für Herstellung elektronischer Vorrichtungen nach Anspruch 8, wobei die zweite Trageauflage (63) wenigstens zwei bogenförmige Halterungen (631) umfasst, die jeweils umfassen:
eine bogenförmige Nut (634);
eine Vielzahl von Durchgangslöchern (633), die in einer Bogenform an dem Umfang der bogenförmigen Nut (634) entlang angeordnet sind; sowie
eine seitliche Halterung (632), an der die Förderbandbaugruppe (61) installiert ist,
wobei beide Enden der seitlichen Halterung (632) selektiv mit zwei Durchgangslöchern (633) der Vielzahl von Durchgangslöchem (633) so in Eingriff gebracht werden, dass die seitliche Halterung (632) in einer veränderlichen Stellung einen Abschnitt der bogenförmigen Nut (634) überspannt.

10. System (1000) für Herstellung elektronischer Vorrichtungen nach einem der Ansprüche 1 bis 9, das des Weiteren wenigstens eine Vorverteilungseinrichtung (400) umfasst, die jeweils umfasst:
wenigstens eine Verteilungsscheibe (401), auf der jeweils eine Vielzahl von Komponenten (200) eines einzelnen Typs im Voraus aufgelegt wird; sowie
einen zweiten Roboter, der so konfiguriert ist, dass er die Komponenten (200) von der Verteilungsscheibe (401) aufnimmt und die aufgenommenen Komponenten (200) in die Aufbewahrungskassette (5) einlegt.

11. System (1000) für Herstellung elektronischer Vorrichtungen nach einem der Ansprüche 1 - 10, wobei die Übertragungsschiene (9) eine Vielzahl zweiter Übertragungseinrichtungen (54) umfasst, die der Reihe nach verbunden sind, und jede der zweiten Übertragungseinrichtungen (54) umfasst:
eine vierte Trageauflage (91), die auf dem Untersatz (1) montiert ist; sowie
eine Übertragungskette (92), die an der vierten Trageauflage (91) installiert ist, wobei die Aufbewahrungskassette (5) so an der Übertragungskette (92) positioniert ist, dass sie sich mit der Übertragungskette (92) bewegt; sowie
eine Antriebswelle (94), die an der vierten Trageauflage (91) installiert ist und die Übertragungskette (92) so antreibt, dass sie sich kreisförmig bewegt, wobei eine Halteeinrichtung (95) an der vierten Trageauflage (91) montiert ist und die Halteeinrichtung (95) so konfiguriert ist, dass sie die Aufbewahrungskassette (5) verschiebbar an der vierten Trageauflage (91) hält.

12. System (1000) für Herstellung elektronischer Vorrichtungen nach einem der Ansprüche 1 bis 11, wobei die Erkennungseinrichtung (3) so konfiguriert ist, dass sie den Typ auf die Aufbewahrungseinrichtung (2) aufgelegter Komponente (200) erkennt.

## Revendications

1. Système de production d'appareil électronique (1000) configuré pour assembler des composants différents éparpillés (200) de différentes formes en un appareil électronique, comprenant :
un rail de transmission (9) sous forme d'une boucle substantiellement fermée ;
une pluralité de plateaux de stockage (5) circulant sur le rail de transmission (9), chacun des plateaux de stockage (5) comprenant une pluralité de parties de maintien (51, 52, 53) pour maintenir les différents composants(200) de différentes formes ;
au moins un équipement de distribution automatique (100) configuré pour monter les différents composants (200) de différentes formes sur les parties de maintien respectives (51, 52, 53) ; et
au moins un équipement d'assemblage automatique (300) configuré pour saisir les différents composants (200) de différentes formes à partir du plateau de stockage (5) dans lequel l'équipement de distribution automatique (100) comprend :
une base (1) ;
un dispositif de stockage (2) monté sur la base (1) et configuré pour stocker la pluralité de composants différents éparpillés (200) de différentes formes ;
un dispositif de reconnaissance (3) configuré pour reconnaître les différents composants (200) de différentes formes placés sur le dispositif de stockage (2) ; et
un dispositif de prélèvement (4) configuré pour prélever les composants différents reconnus (200) de différentes formes et placer les composants différents prélevés (200) de différentes formes sur les parties de maintien respectives (51, 52, 53) du plateau de stockage (5) selon un résultat de reconnaissance du dispositif de reconnaissance (3).

2. Le système de production d'appareil électronique (1000) selon la revendication 1, dans lequel le dispositif de stockage (2) comprend un plateau de support (21) configuré pour placer la pluralité de composants différents dispersés (200) de formes différentes, dans lequel le dispositif de stockage (2) comprend en outre un premier siège de support (22) monté sur la base (1), et
dans lequel le plateau de support (21) est monté sur le première siège de support (22) dans lequel le plateau de support (21) présente une forme substantiellement circulaire, et
dans lequel le dispositif de stockage (2) comprend en outre un premier moteur (27) monté sur le première siège de support (22), et le premier moteur (27) est configuré pour entraîner le plateau de support (21) en rotation.

3. Le système de production d'appareil électronique (1000) selon la revendication 2,
dans lequel une pluralité de plaques de division (26) s'étendant dans une direction radiale sont disposées sur le plateau de support (21), de sorte à diviser le plateau de support (21) en une pluralité de sections de stockage présentant une forme substantiellement en forme d'éventail.

4. Le système de production d'appareil électronique (1000) selon la revendication 2 ou 3
dans lequel une plaque de blocage en forme d'anneau (25) est disposée sur la périphérie du plateau de support (21), de sorte à bloquer les composants (200) pour ne pas qu'ils tombent hors du plateau de support (21).

5. Le système de production d'appareil électronique (1000) selon l'une des revendications 2 à 4,
dans lequel une plaque de blocage en forme d'éventail (24) est disposée sur le plateau de support (21), de sorte à bloquer les composants (200) pour ne pas qu'ils tombent hors du plateau de support (21).

6. Le système de production d'appareil électronique (1000) selon l'une quelconque des revendication 1 à 5, dans lequel l'équipement de distribution automatique (100) comprenant en outre :
un premier dispositif de transmission (6) configuré pour transmettre les différents composants (200) vers le dispositif de stockage (2) dans lequel le premier dispositif de transmission (6) comprenant :
un deuxième siège de support (63) monté sur la base (1) ;
un assemblage de courroie de convoyeur (61) monté sur le deuxième siège de support (63) et comprenant une extrémité de réception (611) pour recevoir les composants (200) et une extrémité de libération (612) pour libérer les composants (200) ; et
un deuxième moteur (62) monté sur le deuxième siège de support (63) et configuré pour entraîner une courroie de convoyeur (614) de l'assemblage de courroie de convoyeur (61) en déplacement, dans lequel l'équipement de distribution automatique (100) comprenant en outre :
un dispositif de chargement (7) configuré pour charger les composants (200) sur l'extrémité de réception (611) de l'assemblage de courroie de convoyeur (61), dans lequel le dispositif de chargement (7) comprenant :
un tambour de roulement (71), orienté dans une direction substantiellement horizontale, dans lequel l'extrémité de réception (611) de l'assemblage de courroie de convoyeur (61) est insérée dans une direction substantiellement horizontale ;
un dispositif d'entraînement (73) configuré pour entraîner le tambour de roulement (71) en rotation ; et
au moins une plaque de raclement (72) montée sur une paroi interne du tambour de roulement (71) dans une direction axiale.

7. Le système de production d'appareil électronique (1000) selon la revendication 6, dans lequel le dispositif de chargement (7) comprend en outre :
un dispositif d'entrée (74) communiqué avec un espace interne du tambour de roulement (71) à l'autre extrémité du tambour de roulement (71) opposée à l'une extrémité du tambour de roulement (71) pour insérer l'extrémité de réception (611) de l'assemblage de courroie de convoyeur (61), de sorte à faire entrer les composants (200) dans le tambour de roulement (71).

8. Le système de production d'appareil électronique (1000) selon l'une quelconque des revendications 6 et 7,
dans lequel un angle d'une surface de l'assemblage de courroie de convoyeur (61) par rapport à un plan horizontal est ajustable dans une direction latérale perpendiculaire à une direction de transmission de la courroie de convoyeur (614).

9. Le système de production d'appareil électronique (1000) selon la revendication 8, dans lequel le deuxième siège de support (63) comprend au moins deux fixations arquées (631) chacune comprenant :
une gorge arquée (634) ;
une pluralité de trous traversants (633) disposée en forme arquée le long d'une périphérie de la gorge arquée (634) ; et
une fixation latérale (632) sur laquelle l'assemblage de courroie de convoyeur (61) est monté,
dans lequel les deux extrémités de la fixation latérale (632) sont sélectivement engagées dans deux trous traversants (633) de la pluralité de trous traversants (633), de sorte que la fixation latérale (632) enjambe une partie de la rainure arquée (634) dans une posture modifiable.

10. Le système de production d'appareil électronique (1000) selon l'une des revendications 1 à 9, comprenant en outre au moins un équipement de pré-distribution (400) chacun comprenant :
au moins un disque de distribution (401) sur chacun duquel une pluralité de type unique de composants (200) sont pré-positionnés ; et
un deuxième robot configuré pour saisir les composants (200) à partir du disque de distribution (401) et monter les composants saisis (200) sur le plateau de stockage (5) .

11. Le système de production d'appareil électronique (1000) selon l'une quelconque des revendications 1 à 10, dans lequel le rail de transmission (9) comprenant une pluralité de deuxièmes dispositifs de transmission (54) connectés tour à tour, et chacun des deuxièmes dispositifs de transmission (54) comprenant :
un quatrième siège de support (91) monté sur la base (1) ; et
une chaîne de transmission (92) montée sur le quatrième siège de support (91), dans lequel le plateau de stockage (5) est placé sur la chaîne de transmission (92), de sorte à se déplacer avec la chaîne de transmission (92) ; et
un arbre d'entraînement (94) monté sur le quatrième siège de support (91), de sorte à entraîner la chaîne de transmission (92) en déplacement circulaire, dans lequel un dispositif de rétention (95) est monté sur le quatrième siège de support (91), et le dispositif de rétention (95) est configuré pour retenir en coulissement le plateau de stockage (5) sur le quatrième siège de support (91).

12. Le système de production d'appareil électronique (1000) selon l'une des revendications 1 à 11, dans lequel le dispositif de reconnaissance (3) est configuré pour reconnaître le type de composant (200) placé sur le dispositif de stockage.
